# EUROPÄISCHE PATENTSCHRIFT

(11) **EP 4 220 315 B1**
(45) Veröffentlichungstag und Bekanntmachung des Hinweises auf die Patenterteilung: **08.10.2025**
(21) Anmeldenummer: 22153786.3
(22) Anmeldetag: 27.01.2022
(51) Int. Cl.: G05B 19/042

(54) **FELDGERÄT**
FIELD DEVICE
APPAREIL DE TERRAIN

(43) Veröffentlichungstag der Anmeldung: 02.08.2023
(73) Patentinhaber: VEGA Grieshaber KG, 77709 Wolfach (DE)
(72) Erfinder: Allgaier, Volker, 77716 Haslach i.K. (DE); Schätzle, Ralf, 77716 Fischerbach (DE); Kaspar, Stefan, 77716 Hofstetten (DE)
(74) Vertreter: Patentanwälte Bauer Vorberg Kayser

(56) Entgegenhaltungen:
- DE-A1- 102010 063 226
- DE-A1- 102017 216 677

## Beschreibung

Die vorliegende Erfindung betrifft ein Feldgerät gemäß dem Oberbegriff des Patentanspruchs 1.

In der Prozessautomatisierungstechnik werden vielfach Feldgeräte eingesetzt, die zur Erfassung und/oder Beeinflussung von Prozessvariablen dienen. Beispiele für derartige Feldgeräte sind Füllstandmessgeräte, Grenzstandmessgeräte und Druckmessgeräte mit Sensoren, die die entsprechenden Prozessvariablen Füllstand, Grenzstand oder Druck erfassen. Häufig sind solche Feldgeräte mit übergeordneten Einheiten, zum Beispiel Leitsystemen oder Steuereinheiten, verbunden. Diese übergeordneten Einheiten dienen zur Prozesssteuerung, Prozessvisualisierung und/oder Prozessüberwachung. Die aus dem Stand der Technik bekannten Feldgeräte weisen in der Regel ein Gehäuse, einen Sensor und ein in dem Gehäuse angeordnetes Elektronikmodul auf.

Die Energie- und/oder Signalübertragung zwischen Feldgerät und übergeordneten Einheiten erfolgt häufig nach dem bekannten 4 mA bis 20 mA Standard, bei dem eine 4 mA bis 20 mA Stromschleife beziehungsweise eine Zweidrahtleitung zwischen dem Feldgerät und der übergeordneten Einheit ausgebildet ist. Zusätzlich zu der analogen Übertragung von Signalen besteht die Möglichkeit, dass die Messgeräte gemäß verschiedenen anderen Protokollen, insbesondere digitalen Protokollen, weitere Informationen an die übergeordnete Einheit übermitteln oder von dieser empfangen. Beispielhaft seien hierfür das HART-Protokoll oder das Profibus-PA-Protokoll genannt.

Die Energieversorgung dieser Feldgeräte erfolgt ebenfalls über das 4 mA bis 20 mA Stromsignal, sodass neben der Zweidrahtleitung keine zusätzliche Versorgungsleitung notwendig ist. Um den Verdrahtungs- und Installationsaufwand sowie die Sicherheitsmaßnahmen, beispielsweise beim Einsatz in explosionsgeschützten Bereichen, so gering wie möglich zu halten, ist es auch nicht gewünscht, zusätzliche Stromversorgungsleitungen vorzusehen.

Aus dem Stand der Technik sind beispielsweise externe Bedieneinheiten bekannt, die zur Kommunikation mit dem Feldgerät physikalisch an die 4 mA bis 20 mA Stromschleife angeschlossen werden, um so die Bedienung des Feldgerätes über die 4 mA bis 20 mA Stromschleife mittels des HART-Protokolls zu ermöglichen. Derartige externe Bedieneinheiten weisen den Nachteil auf, dass sie wie bereits erwähnt, physikalisch an die 4 mA bis 20 mA Stromschleife angeschlossen werden müssen. Hierzu muss die Zweidrahtleitung derartig modifiziert, beispielsweise abisoliert und/oder durchtrennt werden, sodass die Bedieneinheit angeschlossen werden kann. Dies stellt einen relativ hohen Aufwand dar und ist vor Ort nicht immer ohne Weiteres zu bewerkstelligen.

Aus dem Stand der Technik ist es ferner bekannt, Funkmodule zur leichteren Bedienung von Feldgeräten zu verwenden. Es sind Lösungen bekannt, bei denen die Feldgeräte integrierte Funkmodule aufweisen, Funkmodule aufwändig nachgerüstet werden oder in einem Messumformerspeisegerät, einer Einrichtung zur Energieversorgung der Feldgeräte, angeordnet sind. Insbesondere bei den Varianten mit integriertem Funkmodul oder mit einem Funkmodul, das nachgerüstet werden soll, besteht im Stand der Technik das Problem, dass bei einer Energieversorgung über die 4 mA bis 20 mA Stromschleife nur äußerst geringe Leistungen zur Verfügung stehen und die über die Stromschleife zuführbare Energie teilweise nicht ausreicht, um das Funkmodul, das Elektronikmodul und den Sensor gleichzeitig mit ausreichend Energie zu versorgen, sodass ein Betrieb nicht oder nur erschwert möglich ist.

Im Stand der Technik sind hierfür Lösungen bekannt, bei denen das Funkmodul mit einer eigenen Versorgungsleitung versehen ist oder zusätzliche Batterien zum Betrieb des Funkmodules in dem Feldgerät vorgesehen sind. Eigene Versorgungsleitungen bedingen aber den oben genannten erhöhten Installations- und Sicherheitsaufwand, der vermieden werden soll. Sämtliche mit Funkmodulen ausgerüsteten Feldgeräte bringen dabei zusätzlich das Risiko mit sich, dass diese nicht immer vollständig kontrollierbar sind, sodass ein ungewolltes Bedienen oder auch eine bewusste Manipulation nicht jederzeit ausgeschlossen oder verhindert werden könnte.

Weiterer Stand der Technik ist bekannt aus DE 10 2010 063226 A1 und DE 10 2017 216677 A1.

Es ist die Aufgabe der vorliegenden Erfindung, eine einfache Nachrüstung von sicheren Funkmodulen mit erweitertem Funktionsumfang zu ermöglichen und Angriffe durch gezielte Manipulation von Feldgeräten auszuschließen, da diese ein zunehmendes Risiko darstellen.

Der Erfindung liegt damit die Aufgabe zugrunde, ein bekanntes Feldgerät mit vorzugsweise modularem Aufbau derart weiterzubilden, dass die aus dem Stand der Technik bekannten Nachteile und Risiken vermieden werden.

Diese Aufgabe wird durch ein Feldgerät mit den Merkmalen des Patentanspruchs 1 gelöst. Vorteilhafte Ausgestaltungen und Varianten der Erfindung ergeben sich aus den Unteransprüchen und der nachfolgenden Beschreibung. Die in den Unteransprüchen einzeln aufgeführten Merkmale können in beliebiger, technisch sinnvoller Weise sowohl miteinander, als auch mit den in der nachfolgenden Beschreibung näher erläuterten Merkmale kombiniert werden und andere vorteilhafte Ausführungsvarianten der Erfindung darstellen.

Ein erfindungsgemäßes Feldgerät der Automatisierungstechnik weist ein Funkmodul auf, wobei das Funkmodul so ausgebildet ist, dass es wenigstens einen ersten Funkkanal und einen zweiten Funkkanal ausbildet, wobei der erste Funkkanal für einen lesenden Zugriff und der zweite Funkkanal für einen schreibenden Zugriff auf das Feldgerät ausgebildet ist. Erfindungsgemäß ist der zweite Funkkanal in einem Grundzustand des Feldgeräts deaktiviert und das Feldgerät weist ein wenigstens teilweise in Hardware realisiertes Schaltelement auf, wobei das Schaltelement so ausgebildet ist, dass der zweite Funkkanal aktivierbar ist.

Ein Feldgerät ist eine technische Einrichtung im Bereich der Automatisierungstechnik, die mit einem Produktionsprozess in direkter Beziehung steht. "Feld" bezeichnet in der Automatisierungstechnik den Bereich außerhalb von Schaltschränken bzw. Leitwarten. Feldgeräte können somit sowohl Aktoren als auch Sensoren (Messumformer) in der Fabrik- und Prozessautomation sein.

Unter einem Funkmodul gemäß der vorliegenden Anmeldung soll eine Einheit aus einem Funksender und einem Funkempfänger verstanden werden, die einerseits für eine Funkkommunikation mit einer übergeordneten Einheit und anderseits zur Kommunikation mit einer Feldgeräteelektronik des Feldgeräts ausgebildet ist. Der Funksender und Funkempfänger können als eine Einheit ausgebildet sein, aber auch voneinander getrennt. Ferner können mehrere Funksender und/oder mehrere Funkempfänger für unterschiedliche Funkstandards verbaut sein.

Insbesondere können beliebige Kommunikationsstandards für Nahdistanzkommunikation und/oder Ferndistanzkommunikation eingesetzt werden. Beispielsweise kann das Funkmodul ein WLAN- (Wireless Local Area Network), ein GPRS- (General Packet Radio Service), ein Mobilfunk-, ein LTE- (Long Term Evolution), ein 3G-, ein 4G-, ein 5G Funkmodul sein. Auch andere Funkmodule wie NBIoT-, Zigbee, Sigfox, LPWAN-, LoRa-, Bluetooth-, Bluetooth-LE-Module können zum Einsatz kommen. Es können mehrere derartige Kommunikationsmodule vorgesehen sein, um über unterschiedliche Kommunikationsstandards oder eine Kombination daraus eine Kommunikation zu ermöglichen. Bspw. können NB-IoT oder LoRa Technologien für die Funkübertragung zum Einsatz kommen. Mit diesen Technologien ist es möglich lange Distanzen drahtlos zu überbrücken. Zusätzlich können aber auch Nahdistanzfunkmodule, wie bspw. Bluetooth oder NFC verwendet werden, um eine komfortable Parametrierung über kurze Distanzen, bspw. mittels eines tragbaren Eingabegeräts auszuführen.

Unter einem Funkkanal gemäß der vorliegenden Anmeldung soll ein separater Kommunikationsweg verstanden werden, über den Daten und Werte übertragen werden können. Der erste Funkkanal ist für einen lesenden Zugriff ausgebildet, d.h. es können über den ersten Funkkanal Daten des Feldgeräts, insbesondere aus einem Speicher des Feldgeräts gelesen werden, während der zweite Funkkanal einen schreibenden Zugriff, d.h. das Verändern und/oder Erstellen von Einträgen in einem Speicher des Feldgeräts ermöglicht. Der Speicher, auf den der erste Funckanal zugreift und der Speicher, auf den der zweite Funkkanal zugreift, kann durch verschiedene Speicherbereiche eines gemeinsamen physischen Speichers realisiert sein. Es können aber auch voneinander getrennte Speicherbausteine vorgesehen sein.

Ein Funkkanal ist damit insbesondere nicht als eine bestimmte Frequenz oder als Frequenzbereich zu erstehen, auf dem physikalisch Signale übertragen werden.

Erfindungsgemäß weist das Funkmodul ein wenigstens teilweise in Hardware realisiertes Schaltelement auf, das so ausgebildet ist, dass der zweite Funkkanal aktivierbar ist. Das Schaltelement kann dabei vollständig in Hardware realisiert sein, insbesondere aber als eine Kombination aus Hard- und Software ausgebildet sein. Eine Deaktivierung des schreibenden Zugriffs kann dabei dadurch erfolgen, dass ein schreibender Zugriff auf einem dem zweiten Funkkanal zugeordneten Speicher oder Speicherbereich gesperrt wird, und/oder dadurch, dass eine physikalische Unterbrechung des zweiten Funkkanals erfolgt.

Eine vollständige Hardwarerealisierung kann bspw. eine Leitung zwischen dem Funkmodul insbesondere dem Funkempfänger des Funkmoduls und einer Elektronik des Feldgeräts unterbrechen oder für die Signale undurchlässig schalten.

Bevorzugt ist aber eine Realisierung als eine Kombination aus Hard- und Software, wobei ein in Hardware realisierter Schalter oder Taster durch die Software ausgelesen werden und entsprechend softwareseitig der Zugriff aktiviert werden kann. Ausschlaggebend ist aber, dass eine rein softwarebasierte Aktivierung des zweiten Funkkanals und damit des schreibenden Zugriffs ausgeschlossen ist, sodass zwingend eine Betätigung des in Hardware realisierten Schalters oder Tasters vor Ort erfolgen muss.

Erfindungsgemäß ist der zweite Funkkanal und damit der schreibende Zugriff durch das Schaltelement aktivierbar, d.h. dass der zweite Funkkanal zunächst inaktiv ist und durch das Schaltelement in einen aktiven Zustand überführbar ist. Auf diese Weise wird ein schreibender Zugriff durch Personen, die keinen unmittelbaren physischen Zugriff auf das Feldgerät haben, verhindert. Nur wer einen physischen Zugriff auf das Feldgerät hat und durch eine Betätigung des Schaltelements den zweiten Funkkanal aktivieren kann, kann einen schreibenden Zugriff auf das Feldgerät erhalten.

Durch die drahtlose Kommunikation über den ersten und den zweiten Funkkanal besteht die Möglichkeit Messwerte vom Feldgerät zu einer übergeordneten Einheit, bspw. einem Cloudsystem wie dem von der Anmelderin angebotenen VEGA Inventory System zu übertragen. Zusätzlich ist es auch möglich Werte von der übergeordneten Einheit zum Feldgerät bzw. dem Funkmodul bzw. einem in dem Feldgerät verbauten Sensor zu übertragen. Solche Werte können Parameter oder aber auch Softwareupdatepakte für das Feldgerät bzw. den Sensor sein. Genauso ist es natürlich möglich, nicht nur Parameter zum Feldgerät zu überbetragen und dort in einen Speicher zu schreiben, sondern auch zu lesen. Mit dieser Funktionalität ist es möglich den Sensor komplett aus der Ferne einzustellen und auch mit Softwareupdates zu versorgen.

Durch die vorliegende Erfindung kann effektiv verhindert werden, dass ein unberechtigter schreibender Zugriff auf den Sensor erfolgt und bspw. eine unautorisierte Parameteränderung vorgenommen, oder gar Schadsoftware installiert wird. Ferner bleibt aber ein lesender Zugriff weiterhin möglich. Erfindungsgemäß ist ausschließlich ein schreibender Zugriff in einem Grundzustand des Feldgeräts deaktiviert und kann aktiviert werden. Ein lesender Zugriff soll dauerhaft möglich sein

In einer Weiterbildung des Feldgeräts ist das Schaltelement derart ausgebildet, dass der zweite Funkkanal deaktivierbar ist. Es kann damit durch eine Betätigung des Schaltelements sowohl eine Aktivierung als auch eine Deaktivierung des zweiten Funkkanals und damit des schreibenden Zugriffs auf das Feldgerät erfolgen.

Zusätzlich oder alternativ zu einer manuellen Deaktivierung des zweiten Funkkanals kann das Schaltelement mit einem Timer derart gekoppelt sein, dass der zweite Funkkanal nach Ablauf einer vorgebbaren Zeit nach einer Aktivierung automatisch deaktiviert wird. Auf diese Weise kann effektiv sichergestellt werden, dass das Feldgerät nach einer Aktivierung des zweiten Funkkanals, bspw. für eine Parametrierung des Feldgeräts, für die ein schreibender Zugriff notwendig ist, automatisch wieder in einen Zustand zurückkehrt, in dem der zweite Funkkanal deaktiviert ist, sodass kein schreibender Zugriff auf das Feldgerät möglich ist. So kann eine Veränderung von Parametern durch unbefugt Personen effektiv verhindert werden.

Zusätzlich kann das Schaltelement derart ausgebildet und angeordnet sein, dass eine Betätigung nur dann möglich ist, wenn das Funkmodul von dem Feldgerät abgenommen ist. Durch eine entsprechende Ausgestaltung wird ein Trennen des Funkmoduls von dem Feldgerät für eine Betätigung des Schaltelements notwendig. Eine solche Trennung wird von dem Feldgerät und auch von einer übergeordneten Einheit registriert, sodass eine Aktivierung des zweiten Funkkanals jedenfalls auf diese Weise erkannt werden kann. Ferner ist durch eine entsprechende mechanische Anordnung sichergestellt, dass ein versehentliches Aktivieren oder Deaktivieren des schreibenden Zugriffs ausgeschlossen wird.

In einer Ausgestaltung ist das Funkmodul mechanisch derart verankert und das Schaltelement ist an einer Unterseite des Funkmoduls so angeordnet, dass das Schaltelement nur nach Lösen der Verankerung und Entnehmen des Funkmoduls aus einem Gehäuse des Feldgeräts zugänglich ist. Ist beispielsweise das Funkmodul mechanisch mittels eines Rast- oder Bajonettverschlusses an dem Elektronikmodul befestigt, so kann ein an der Unterseite des Funkmoduls, d. h. an einer dem Elektronikmodul zugewandten Seite des Funkmoduls angeordnetes Bedienelement nur bedient werden, wenn die mechanische Verankerung des Funkmoduls gelöst und diese von dem Elektronikmodul entfernt wird.

In einer Weiterbildung kann das Funkmodul in ein Anzeige- und/oder Bedienmodul integriert sein. Feldgeräte weisen häufig ein abnehmbares und auswechselbares Anzeige- und/oder Bedienmodul auf, das bspw. zur Anzeige von Messwerten und Parametern vor Ort und/oder zur Eingabe und Parametrierung des Feldgeräts genutzt werden kann. Ein solches Anzeige- und/oder Bedienmodul kann mit einem Funkmodul ergänzt werden, sodass das Funkmodul in das Anzeige- und/oder Bedienmodul integriert ist. Durch eine Integration des Funkmoduls in ein solches Anzeige- und/oder Bedienmodul kann ein platzsparender Aufbau sowie ein elektrisch günstiger Aufbau erreicht werden, da das Anzeige- und/oder Bedienmodul in der Regel bereits entsprechende Elektronikkomponenten für eine Anzeige von Messwerten und/oder die Konfiguration des Feldgerätes aufweist. In einer solchen Konfiguration ist es möglich, dass das Funkmodul lediglich die bereits aufbereiteten Messwerte oder entsprechende Konfigurationsmerkmale übermittelt und so entsprechende Elektronikkomponenten nicht mehrfach verbaut werden müssen. In diesem Fall kann der in Hardware realisierte Teil des Schaltelements von außen zugänglich an dem Anzeige- und/oder Bedienmodul angeordnet sein, bevorzugt aber so, dass in diesem Fall das Anzeige- und/oder Bedienmodul derart mechanisch an dem Feldgerät angeordnet und verankert ist, dass das Schaltelement nur nach Lösen der Verankerung und Entnehmen des Anzeige- und/oder Bedienmoduls aus einem Gehäuse des Feldgeräts zugänglich ist.

Der in Hardware realisierte Teil des Schaltelements kann bspw. einen Schalter oder einen Taster sein, der mit einer Ansteuerelektronik des Funkmoduls derart gekoppelt ist, dass der zweite Funkkanal aktivierbar und/oder deaktivierbar ist.

Wenn der zweite Funkkanal ausschließlich für einen schreibenden Zugriff auf einen Parameterspeicher des Feldgeräts ausgebildet ist, kann ohne weitere Einschränkungen genau und ausschließlich dieser Zugriff verhindert und damit eine erhöhte Sicherheit des Feldgeräts bewerkstelligt werden.

Das Feldgerät weist ferner einen unabhängigen Kommunikationskanal auf, der einen lesenden Zugriff wenigstens auf Diagnosedaten des Feldgeräts ermöglicht. Der unabhängige Kommunikationskanal kann kabellos oder kabelgebunden ausgeführt sein. Bspw. kann der unabhängige Kommunikationskanal der erste Funkkanal sein, oder ein kabelgebundener Kommunikationskanal, der einen lesenden Zugriff auf die Diagnosedaten ermöglicht. Gerade bei Bestandsanlagen ist dieser Ansatz interessant, da häufig schon intelligente Geräte im Feld verbaut sind, Diagnosedaten aber weitestgehend ungenutzt bleiben.

Durch einen Zugriff auf die Diagnosedaten wird eine umfassendere Analyse der Feldgerätefunktion sowie der Messwerte ermöglicht. Bspw. können aufgrund der Diagnosedaten nachträgliche Messwertkompensationen erfolgen, oder eine vorausschauende Wartung des Feldgeräts veranlasst werden, noch bevor ein Fehlerzustand auftritt. Bei einem Fehlerzustand können detaillierte Diagnoseinformationen helfen die genaue Ursache zu erkennen, damit dieser schnellstmöglich beseitigt werden kann.

Der unabhängige Kommunikationskanal kann auch kabelgebunden realisiert sein. Beispielsweise kann die lesende Kommunikation über ein Ethernet-Modul und/oder ein LAN-Modul (Local Area Network) oder dergleichen erfolgen. Auch kann die Kommunikation über einen Feldbus, wie beispielsweise einen HART Bus, einen Profibus, einen Foundation-Fieldbus-Bus, einen Modbus, einem SDI-12-Bus, einen EthernetIP-Bus, einem Profinet-Bus, einen IP basierten Bus, einen Ethernet-IP-Bus, APL, einen seriellen Bus und/oder einen parallelen Bus erfolgen. Auch andere Kommunikationsverbindungen, z.B. über IO-Link, eine 4-20 mA/HART-Schnittstelle und/oder eine USB-Verbindung, sind denkbar.

Um die Sicherheit gegen unbefugten Zugriff weiter zu erhöhen kann das Feldgerät mechanisch verriegelbar und gegen unbefugte Bedienung sicherbar ausgestaltet sein. Bspw. kann das Feldgerät eine Verriegelung in Form eines Schlosses aufweisen.

Offenbart, aber nicht beansprucht ist ferner ein modulares Feldgerätesystem zum Aufbau von Feldgeräten, wobei das modulare Feldgerätesystem eine Mehrzahl von Gehäusen, eine Mehrzahl von Sensoren, eine Mehrzahl von mit den Sensoren verbindbaren Elektronikmodulen und einer Mehrzahl von mit den Elektronikmodulen verbindbaren Anzeige- und/oder Bedieneinheiten aufweist, und wobei das Feldgerätesystem wenigstens ein Anzeige- und/oder Bedienmodul mit einem Funkmodul zur drahtlosen Kommunikation mit wenigstens einer weiteren Einheit aufweist, wobei das Funkmodul wenigstens einen ersten Funkkanal und einen zweiten Funkkanal ausbildet, wobei der erste Funkkanal für einen lesenden Zugriff und der zweite Funkkanal für einen schreibenden Zugriff auf das Feldgerät ausgebildet ist. Das modulare Feldgerätesystem zeichnet sich erfindungsgemäß dadurch aus, dass wenigstens eine Anzeige- und/oder Bedieneinheit ein Funkmodul und ein wenigstens teilweise in Hardware realisiertes Schaltelement aufweist, wobei das Schaltelement so ausgebildet ist, dass der schreibende Zugriff auf das Feldgerät aktivierbar ist.

Bei einem modularen Feldgerätekonzept können aus einer Mehrzahl von kombinierbaren Sensoren, Gehäusen, Elektronikmodulen und Bedien- und/ oder Anzeigemodulen jeweils ein Modul ausgewählt und ein entsprechendes Feldgerät aufgebaut werden. Ein solches modulares Feldgerätekonzept wird bspw. von der Firma Vega Grieshaber KG angeboten. Kombinierbar sind in der Regel je ein Sensor zur Überführung der zu messenden Größe in ein elektrisches Signal, ein entsprechendes Elektronikmodul, das eine Messwertverarbeitung und verschiedene Schnittstellen beispielsweise zu einer Steuerung und ggf. verschiedene Kommunikationsmedien bereitstellt und eine Energieversorgung beinhaltet, sowie verschiedene Anzeige- und/oder Bedienmodule. Die Sensoren, Elektronikmodule und Anzeige und/oder Bedienmodule sind sowohl aneinander als auch an verschiedene verfügbare Gehäuse angepasst.

Das Elektronikmodul weist dabei verschiedene Komponenten auf, die in einer Einheit zusammengefasst sind und vorzugsweise eine eigeständig handhabbare Einheit bilden. Insbesondere kann das Elektronikmodul Schnittstellen zu einem oder mehreren Messwandlern (Sensoren) und/oder Anzeige- und/oder Bedienmodule aufweisen, wobei die Schnittstellen leitungsgebunden und/oder drahtlose ausgeführt sein können. Das Elektronikmodul kann dabei ferner insbesondere Schaltungskomponenten zur Messwertverarbeitung, d.h. insbesondere Recheneinheiten, wie bspw. Applikationsspezifische integrierte Schaltungen (ASIC = Application Specific Integrated Circuit), Controller oder Prozessoren, Filter, oder dergleichen sowie optional einen oder mehrere Speichereinheiten umfassen. Ferner kann das Elektronikmodul eine oder mehrere Kommunikationsschnittstellen aufweisen, insbesondere zur Kommunikation mit einer übergeordneten Einheit, einem Anzeige- und/oder Bedienmodul und/oder dem Sensor. Die Kommunikationsschnittstellen können als digitale oder analoge Schnittstellen ausgebildet sein und eine direkte Punkt-zu-Punkt Kommunikation und/oder eine Buskommunikation und/oder eine paketvermittelte, bspw. Ethernet-Kommunikation unterstützen. Die Kommunikationsschnittstellen können bidirektional oder unidirektional ausgebildet sein. Die Kommunikationsschnittstellen können ferner kabelgebunden oder kabellos ausgebildet sein und entsprechend kabelgebundene und/oder kabellose, d.h. insbesondere Funk-Kommunikation und Kommunikationsprotokolle unterstützen. Ferner kann das Elektronikmodul zusätzlich eine Energieversorgung des Feldgeräts bereitstellen, bspw. in Form einer Energieschnittstelle, vorzugsweise in Form eines Energieeingangs und/oder eines Energiespeichers.

In einer Variante weist das Elektronikmodul vorzugsweise eine kombinierte Energie- und Datenschnittstelle auf bei der gleichzeitig eine Energie- und Datenübertragung erfolgt. Bevorzugt werden Zweileiterschnittstellen, da diese eigensicher ausgestaltet werden können. Eine kombinierte Energie- und Datenschnittstelle kann bspw. gemäß dem 4-20 mA Standard, mit analoger oder digitaler Datenübertragung, bspw. gemäß dem HART-Protokoll ausgebildet sein. Zusätzlich oder alternativ kann das Elektronikmodul auch eine Zweidraht-Ethernetschnittstelle aufweisen, die vorzugsweise eine Kommunikation gemäß dem Ethernet APL Standard implementieren kann.

Es sei an dieser Stelle angemerkt, dass sämtliche zuvor genannten Schnittstellen sowohl eine mechanische Schnittstelle und/oder eine elektrische Schnittstelle und/oder eine Datenschnittstelle ausbilden können.

Das Feldgerät ist vorzugsweise als modulares Feldgerät ausgebildet, wobei es wenigstens einen Messumformer, ein an den Messumformer angepasstes Elektronikmodul sowie ein daran angepasstes Anzeige- und/oder Bedienmodul mit einem Funkmodul aufweist, das wenigstens einen ersten Funkkanal und einen zweiten Funkkanal ausbildet, wobei der erste Funkkanal für einen lesenden Zugriff und der zweite Funkkanal für einen schreibenden Zugriff auf das Feldgerät ausgebildet ist, wobei das Feldgerät und insbesondere das Funkmodul gemäß der vorstehenden Beschreibung ausgebildet ist.

Die vorliegende Erfindung wird nachfolgend anhand von Ausführungsbeispielen unter Bezugnahme auf die beigefügten Figuren eingehend erläutert. Es zeigen:
- Figur 1: eine Explosionsdarstellung eines Feldgeräts gemäß der vorliegenden Anmeldung und
- Figur 2: ein Blockschaltbild des Feldgerätes gemäß Figur 1

In den Figuren bezeichnen - soweit nicht anders angegeben - gleiche Bezugszeichen gleiche oder einander entsprechende Komponenten mit gleicher Funktion.

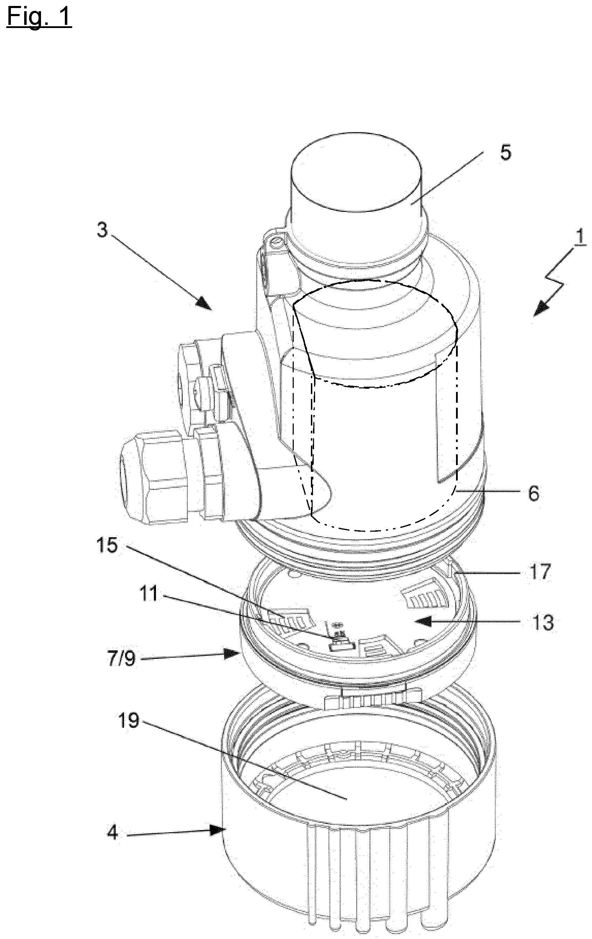

Figur 1 zeigt eine Explosionsdarstellung einer perspektivischen Ansicht eines Feldgeräts 1 gemäß der vorliegenden Anmeldung.

Das Feldgerät 1 weist im Wesentlichen ein Gehäuse 3 auf, in dem ein Elektronikmodul 6 (vorliegend innerhalb des Gehäuses mit einer gestrichelten Linie angedeutet) angeordnet ist. Einenends ist mit dem Elektronikmodul 6 ein vorliegend nur schematisch dargestellter Sensor 5 verbunden, der an dem Gehäuse 3 angeordnet ist. Der Sensor 5 kann aber auch über entsprechende Messleitungen von dem Gehäuse 3 abgesetzt und beispielsweise über entsprechende Verlängerungen in einer Messumgebung angeordnet sein.

Das Feldgerät 1 kann beispielsweise über eine Zweidrahtleitung, die durch eine entsprechende Öffnung des Gehäuses 3 geführt ist, mit einer übergeordneten Einheit, beispielsweise einer Steuer-, Leit- oder Messwarte verbunden sein und über diese Leitung gleichzeitig mit Energie versorgt werden.

Das Elektronikmodul 6 weist dabei verschiedene Komponenten auf, die in einem gemeinsamen Innengehäuse, dem sog. Elektronikbecher untergebracht und zu einer Einheit zusammengefasst sind. Das Elektronikmodul 6 ist so als eine Komponente handhabbar. Das Elektronikmodul 6 weist eine Schnittstelle zu dem Sensor 5 und eine weitere Schnittstelle zu einem Anzeige- und Bedienmodul 7 auf, wobei die Schnittstellen im vorliegenden Ausführungsbeispiel leitungsgebunden ausgeführt sind. Das Elektronikmodul 6 weist ferner Schaltungskomponenten zur Messwertverarbeitung, d.h. insbesondere Recheneinheiten, vorliegend einen Controller sowie einen Speicher für die Abspeicherung von Messdaten, Diagnosedaten, Betriebsparametern und Betriebsprogrammen des Feldgeräts 1 auf. In alternativen Ausgestaltungsformen sind auch mehrere Controller und/oder Speicher möglich.

Ferner weist das Elektronikmodul 6 mehrere Kommunikationsschnittstellen zur Kommunikation mit einer Leitwarte auf. Die Kommunikationsschnittstelle ist im vorliegenden Fall als kombinierte Energie- und Datenschnittstelle auf der gleichzeitig eine Energie- und Datenübertragung erfolgt ausgebildet. Im vorliegenden Ausführungsbeispiel ist die Kommunikationsschnittstelle als Ethernet-APL Schnittstelle ausgebildet. Es sind aber auch andere kabelgebundene und auch kabellose Kommunikationsschnittstellen mit und ohne integrierte Energieversorgung für das Feldgerät 1 denkbar.

An einer der Sensorseite gegenüberliegenden Seite des Elektronikmoduls 6 ist im vorliegenden Ausführungsbeispiel ein Anzeige- und/oder Bedienmodul 7 mit einem integrierten Funkmodul 9 angeordnet. Das Anzeige- und/oder Bedienmodul 7 kann über einen an einem umlaufenden Rand des Anzeige- und/oder Bedienmoduls 7 vorgesehenen Bajonettverschluss 17 mit dem Elektronikmodul 6 mechanisch verbunden werden, wobei bei einer mechanischen Verbindung gleichzeitig über Anschlusskontakte 15, die an dem Anzeige- und/oder Bedienmodul 7 unterseitig angeordnet sind, eine elektrische Verbindung hergestellt wird. An einer dem Elektronikmodul 6 abgewandten Seite des Anzeige- und/oder Bedienmoduls 7 ist im vorliegenden Ausführungsbeispiel ein Display zur Anzeige von Messwerten oder anderen gerätespezifischen Informationen sowie ein Tastenfeld zur Eingabe von Bedieninformationen, beispielsweise zur Konfiguration des Elektronikmoduls 6 angeordnet. Das Gehäuse 3 ist im vorliegenden Ausführungsbeispiel mit einem Deckel 4 verschließbar, wobei in dem Deckel 4 ein Sichtfenster 19 angeordnet ist, sodass das Display des Anzeige- und/oder Bedienmoduls 7 auch bei aufgesetztem Deckel 4 von außen sichtbar bleibt.

Mittels der zweiten elektrischen Schnittstelle erfolgt eine Übermittlung von Messwerten an die übergeordnete Einheit und es kann ein separater Kommunikationskanal für einen ausschließlich lesenden Zugriff auf einen Speicherbereich des Feldgeräts 1 etabliert werden, wobei in dem Speicherbereich bspw. Diagnosedaten und Parameter des Feldgeräts 1 abgelegt sind. Bspw. können über den separaten Kommunikationskanal die Diagnosedaten ausgelesen und so eine vorausschauende Gerätewartung bewerkstelligt werden.

Ausschlaggebend ist hierbei, dass der lesende Zugriff rückwirkungsfrei erfolgt, d.h. dass der zusätzliche Kommunikationskanal keine Rückwirkung auf eine Parametrierung oder eine auf dem Feldgerät 1 installierte Software (Firmware) hat. Dies wird dadurch erreicht, dass ein schreibender Zugriff auf den Speicher über einen separaten, als zweiten Funkkanal des Funkmoduls 9 ausgebildeten Kommunikationskanal erfolgt und dieser in einem Grundzustand des Feldgeräts 1 deaktiviert ist.

An dem Anzeige- und/oder Bedienmodul 7 ist im vorliegenden Ausführungsbeispiel an der dem Elektronikmodul 6 zugewandten Seite ein Bedienelement 11 zur Aktivierung und Deaktivierung des zweiten Funkkanals des in dem Anzeige- und/oder Bedienmoduls 7 angeordneten Funkmoduls 9 angeordnet. Das Bedienelement 11 ist im vorliegenden Ausführungsbeispiel als mechanischer Schiebeschalter ausgeführt, kann aber ebenso als Kippschalter, Taster, Magnetschalter oder dergleichen ausgeführt sein. Das Bedienelement 11 wirkt mit einer Steuerungssoftware des Feldgeräts 1 so zusammen, dass ein Schaltelement gebildet ist, das den zweiten Funkkanal und damit den schreibenden Zugriff auf den Speicher nur in einer Schalteerstellung des Schiebeschalters freigibt und ansonsten sperrt.

In einer Variante ist das Bedienelement 11 als Taster ausgebildet. Der Taster ist mit der Steuerungssoftware so verknüpft, dass der zweite Funkkanal bei einer Betätigung des Tasters aktiviert und anschließend nach Ablauf einer vorgegebenen Zeitdauer, vorliegend 15 Minuten wieder automatisch sperrt. Eine erneute Freigabe kann nur durch eine erneute Betätigung des Tasters erfolgen.

Alternativ kann es auch möglich sein die Freigabe durch einen Reset des Timers in der Steuerungssoftware zu verlängern, wobei aber eine initiale Freigabe ausschließlich durch das Bedienelement 11 erfolgt. Um eine zukünftige Verlängerung des Zugriffs auf diese Weise zu unterbinden, kann eine Anzahl von Verlängerungen über die Steuerungssoftware begrenzt werden, beispielsweise auf drei Verlängerungen pro über das Bedienelement 11 initialisierter (gestarteter) Session.

Das Bedienelement 11 ist im vorliegenden Ausführungsbeispiel zur Aktivierung und Deaktivierung des Funkmoduls 9 nur dann zugänglich, wenn das Anzeige- und/oder Bedienmodul 7 von dem Elektronikmodul 6 gelöst und aus dem Gehäuse 3 entnommen wird. Auf diese Weise ist ein effektiver Schutz vor Fehlbedienungen gegeben.

Ferner wird dadurch, dass das Anzeige- und/oder Bedienmodul 7 von dem Elektronikmodul 6 zur Betätigung des Bedienelements 11 abgenommen werden muss, ein Signal an die übergeordnete Einheit gesendet, sodass eine Manipulation zuverlässig erkannt werden kann.

Alternativ kann das Bedienelement 11, also der in Hardware realisierte Teil des Schaltelements, der vorliegend als Schiebeschalter ausgebildet ist, aber auch als Kippschalter, Taster oder Magnetschalter oder dergleichen ausgeführt werden.

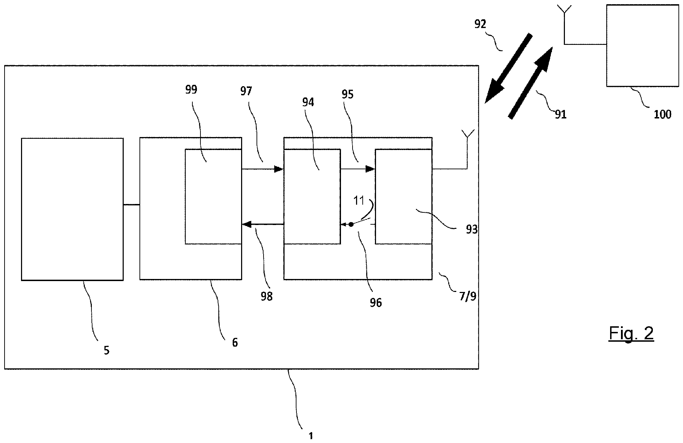

Figur 2 zeigt ein Blockschaltbild des Feldgeräts 1 aus Figur 1 mit einem gemäß der vorliegenden Anmeldung ausgebildeten Funkmodul 9.

Das Blockschaltbild zeigt im Wesentlichen das Elektronikmodul 6, das Anzeige- und /oder Bedienmodul 7 mit dem Funkmodul 9 und eine übergeordnete Einheit mit einer Funkschnittstelle 100.

Das Elektronikmodul 6 weist eine Kommunikationseinheit 99 auf, die das über einen Sendekanal 97 und einen Empfangskanal 98 mit einer zweiten Kommunikationseinheit 94 im Anzeige- und/oder Bedienmodul 7 kommuniziert. Die Kommunikationseinheit 94 ist wiederum über einen Sendekanal 95 und einen Empfangskanal 96 mit einer Sende- und/oder Empfangseinheit 93 des Funkmoduls 9 verbunden. Die Sende- und/oder Empfangseinheit 93 kann Daten über den ersten Funckanal 91 an die übergeordnete Einheit 100 senden und über den zweiten Funkkanal 92 Daten empfangen. Über diese Kommunikationspfade können Daten vom Elektronikmodul 6 an die übergeordnete Einheit 100 gesendet und empfangen werden.

Sendedaten über die Kommunikationspfade 97, 95 und 91 können z.B. Messwerte / Diagnosewerte sein. Empfangsdaten über die Kommunikationspfade 92, 96 und 98 können z.B. Parameterwerte sein, die von der übergeordneten Einheit 100 an das Elektronikmodul 6 gesendet werden und dort in einen Speicherbereich geschrieben werden. Die Kommunikationspfade 97, 98 und 95, 96 können z.B. RXD und TXD-Leitungen einer seriellen Kommunikationsschnittstelle sein.

Eine Ausführung ist z.B. die Realisierung des Bedienelements 11 als ein Hardwareschalter in der Empfangsleitung 96, ist der Schalter geöffnet werden keine Daten mehr zur Kommunikationseinheit 94 und damit zum Elektronikmodul 6 weitergeleitet.

In einer weiteren möglichen Ausführungsform ist der Schalter mit dem Funkmodul 93 verbunden und wird von dem Funkmodul ausgewertet, so dass z.B. bei geöffnetem Schalter keine Daten über den Funkkanal 92 angenommen werden.

### Bezugszeichenliste

- 1: Feldgerät
- 3: Gehäuse
- 4: Deckel
- 5: Sensor
- 6: Elektronikmodul
- 7: Anzeige- und/oder Bedienmodul
- 9: Funkmodul
- 11: Bedienelement
- 15: Anschlusskontakt
- 17: Bajonettverschluss
- 19: Sichtfenster

- 91: erster Funkkanal
- 92: zweiter Funkkanal

## Patentansprüche

1. Feldgerät (1) der Automatisierungstechnik mit
einem Funkmodul (9), wobei das Funkmodul (9) so ausgebildet ist, dass es wenigstens einen ersten Funkkanal (91) und einen zweiten Funkkanal (92) ausbildet, wobei der erste Funkkanal (91) für einen lesenden Zugriff und der zweite Funkkanal (92) für einen schreibenden Zugriff auf das Feldgerät (1) ausgebildet ist,
**dadurch gekennzeichnet, dass**
der zweite Funkkanal (92) in einem Grundzustand des Feldgeräts (1) deaktiviert ist, d.h. der schreibende Zugriff auf das Feldgerät (1) deaktiviert ist, und das Feldgerät (1) ein wenigstens teilweise in Hardware realisiertes Schaltelement aufweist, wobei das Schaltelement so ausgebildet ist, dass der zweite Funkkanal (92) aktivierbar ist.

2. Feldgerät (1) der Automatisierungstechnik gemäß Anspruch 1,
**dadurch gekennzeichnet, dass**
das Schaltelement derart ausgebildet ist, dass der zweite Funkkanal (92) deaktivierbar ist.

3. Feldgerät (1) der Automatisierungstechnik gemäß einem der vorhergehenden Ansprüche,
**dadurch gekennzeichnet, dass**
das Schaltelement mit einem Timer derart gekoppelt ist, dass der zweite Funkkanal (92) nach Ablauf einer vorgebbaren Zeit nach einer Aktivierung automatisch deaktiviert wird.

4. Feldgerät (1) gemäß einem der vorhergehenden Ansprüche,
**dadurch gekennzeichnet, dass**
das Schaltelement ein in Hardware ausgebildetes Bedienelement (11) aufweist.

5. Feldgerät (1) gemäß Patentanspruch 4,
**dadurch gekennzeichnet, dass**
das Bedienelement (11) derart ausgebildet und angeordnet ist, dass eine Betätigung nur dann möglich ist, wenn das Funkmodul (9) von dem Feldgerät (1) abgenommen ist.

6. Feldgerät (1) gemäß einem der vorhergehenden Ansprüche 4 oder 5,
**dadurch gekennzeichnet, dass**
das Funkmodul (9) mittelbar oder unmittelbar mechanisch derart verankert und das Bedienelement (11) an einer in ein Gehäuseinneres weisenden Seite so angeordnet ist, dass das Bedienelement (11) nur nach Lösen der Verankerung und Entnehmen des Funkmoduls (9) aus dem Gehäuse (3) des Feldgeräts (1) zugänglich ist.

7. Feldgerät (1) gemäß einem der vorhergehenden Ansprüche,
**dadurch gekennzeichnet, dass**
das Funkmodul (9) in ein Anzeige- und/oder Bedienmodul (7) integriert ist.

8. Feldgerät (1) gemäß einem der vorhergehenden Patentansprüche,
**dadurch gekennzeichnet, dass**
das Bedienelement (11) als Schalter oder Taster ausgebildet ist, der mit einer Ansteuerelektronik des Funkmoduls (9) derart gekoppelt ist, dass zweite Funkkanal (92) aktivierbar und/oder deaktivierbar ist.

9. Feldgerät (1) gemäß einem der vorhergehenden Ansprüche,
**dadurch gekennzeichnet, dass**
das Feldgerät (1) einen unabhängigen Kommunikationskanal aufweist, der einen lesenden Zugriff auf Diagnosedaten ermöglicht.

10. Feldgerät (1) gemäß einem der vorhergehenden Ansprüche,
**dadurch gekennzeichnet, dass**
der zweite Funkkanal (92) ausschließlich für einen schreibenden Zugriff auf einen Parameterspeicher des Feldgeräts (1) ausgebildet ist.

11. Feldgerät (1) gemäß einem der vorhergehenden Ansprüche,
**dadurch gekennzeichnet, dass**
das Feldgerät (1) mechanisch verriegelbar und gegen unbefugte Bedienung sicherbar ist.

## Claims

1. An automation technology field device (1), comprising
a radio module (9), wherein the radio module (9) is configured such that it forms at least one first radio channel (91) and one second radio channel (92), wherein the first radio channel (91) is configured for a reading access and the second radio channel (92) for a writing access to the field device (1),
**characterized in that**
the second radio channel (92) is deactivated in a basic state of the field device (1) i.e., write access to the field device (1) is disabled,
and the field device (1) has a switching element at least partially realized as hardware, wherein the switching element is configured such that the second radio channel (92) can be activated.

2. The automation technology field device (1) according to claim 1,
**characterized in that**
the switching element is configured such that the second radio channel (92) can be deactivated.

3. The automation technology field device (1) according to any one of the preceding claims,
**characterized in that**
the switching element is coupled to a timer such that the second radio channel (92) is automatically deactivated after a predeterminable time after an activation has elapsed.

4. The field device (1) according to any one of the preceding claims,
**characterized in that**
the switching element has an operating member (11) formed as hardware.

5. The field device (1) according to patent claim 4,
**characterized in that**
the operating member (11) is configured and arranged such that an actuation is possible only when the radio module (9) is removed from the field device (1).

6. The field device (1) according to any one of the preceding claims 4 or 5,
**characterized in that**
the radio module (9) is indirectly or directly mechanically anchored, and the operating member (11) is disposed on a side facing into a housing interior, such that the operating member (11) is accessible only after the anchoring of the radio module (9) has been disconnected and it has been removed from the housing (3) of the field device (1).

7. The field device (1) according to any one of the preceding claims,
**characterized in that**
the radio module (9) is integrated into a display and/or operating module (7).

8. The field device (1) according to any one of the preceding patent claims,
**characterized in that**
the operating member (11) is configured as a switch or button coupled to an electronic control system of the radio module (9) such that the second radio channel (92) can be activated and/or deactivated.

9. The field device (1) according to any one of the preceding claims,
**characterized in that**
the field device (1) has an independent communication channel that enables a reading access to diagnostic data.

10. The field device (1) according to any one of the preceding claims,
**characterized in that**
the second radio channel (92) is configured exclusively for a writing access to a parameter memory of the field device (1).

11. The field device (1) according to any one of the preceding claims,
**characterized in that**
the field device (1) can be mechanically locked and secured against unauthorized operation.

## Revendications

1. Appareil de terrain (1) de la technique d'automatisation comprenant
un module radio (9), le module radio (9) étant conçu pour former au moins un premier canal radio (91) et un deuxième canal radio (92), le premier canal radio (91) étant conçu pour un accès en lecture et le deuxième canal radio (92) étant conçu pour un accès en écriture sur l'appareil de terrain (1),
**caractérisé en ce que**
le deuxième canal radio (92) est désactivé dans un état de base de l'appareil de terrain (1), c'est-à-dire que l'accès en écriture sur l'appareil de terrain (1) est désactivé, et l'appareil de terrain (1) présente un élément de commutation réalisé au moins partiellement de façon matérielle, l'élément de commutation étant conçu de sorte que le deuxième canal radio (92) soit apte à être activé.

2. Appareil de terrain (1) de technique d'automatisation selon la revendication 1,
**caractérisé en ce que**
l'élément de commutation est conçu de manière à ce que le deuxième canal radio (92) puisse être désactivé.

3. Appareil de terrain (1) de technique d'automatisation selon l'une quelconque des revendications précédentes,
**caractérisé en ce que**
l'élément de commutation est couplé à un temporisateur de manière à ce que le deuxième canal radio (92) soit automatiquement désactivé après l'écoulement d'un temps prédéterminé après une activation.

4. Appareil de terrain (1) selon l'une quelconque des revendications précédentes,
**caractérisé en ce que**
l'élément de commutation présente un élément de commande (11) conçu en matériel.

5. Appareil de terrain (1) selon la revendication 4,
**caractérisé en ce que**
l'élément de commande (11) est conçu et disposé de manière à ce qu'un actionnement ne soit possible que lorsque le module radio (9) est retiré de l'appareil de terrain (1).

6. Appareil de terrain (1) selon l'une des revendications précédentes 4 ou 5,
**caractérisé en ce que**
le module radio (9) est ancré mécaniquement de manière indirecte ou directe et l'élément de commande (11) est disposé sur un côté orienté vers l'intérieur d'un boîtier de sorte que l'élément de commande (11) n'est accessible qu'après le desserrage de l'ancrage et le retrait du module radio (9) du boîtier (3) de l'appareil de terrain (1).

7. Appareil de terrain (1) selon l'une quelconque des revendications précédentes,
**caractérisé en ce que**
le module radio (9) est intégré dans un module d'affichage et/ou de commande (7).

8. Appareil de terrain (1) selon l'une quelconque des revendications précédentes,
**caractérisé en ce que**
l'élément de commande (11) est conçu comme un commutateur ou un bouton-poussoir qui est couplé à une électronique de commande du module radio (9) de manière à ce que le deuxième canal radio (92) puisse être activé et/ou désactivé.

9. Appareil de terrain (1) selon l'une quelconque des revendications précédentes,
**caractérisé en ce que**
l'appareil de terrain (1) présente un canal de communication indépendant qui permet un accès en lecture à des données de diagnostic.

10. Appareil de terrain (1) selon l'une quelconque des revendications précédentes,
**caractérisé en ce que**
le deuxième canal radio (92) est conçu exclusivement pour un accès en écriture à une mémoire de paramètres de l'appareil de terrain (1).

11. Appareil de terrain (1) selon l'une quelconque des revendications précédentes,
**caractérisé en ce que**
l'appareil de terrain (1) peut être verrouillé mécaniquement et protégé contre toute utilisation non autorisée.
